Europäisches Patentamt

European Patent Office

Office européen des brevets

(11) Publication number: **0 525 851 A1**

## EUROPEAN PATENT APPLICATION

(21) Application number: **92201981.5**

(22) Date of filing: **08.07.92**

(51) Int. Cl.5: **G06F 15/24**, B65G 61/00

(30) Priority: **10.07.91 NL 9101213**

(43) Date of publication of application:
**03.02.93 Bulletin 93/05**

(84) Designated Contracting States:
**AT BE CH DE DK ES FR GB GR IT LI LU NL PT SE**

(71) Applicant: **Koninklijke PTT Nederland N.V.**
**P.O. Box 95321**
**NL-2509 CH The Hague(NL)**

(72) Inventor: **Snellen, Theodorus Cornelis**
**Christianus Maria**
**27 Maystraat**
**2593 VR The Hague(NL)**

(54) Method of filling a space with objects.

(57) Method of automatically filling a rectangular container or pallet with rectangular parcels, in which the dimensions of a number of parcels are stored in a memory and the parcels are placed step-by-step in the form of at least two walls, the respective outsides of the outermost walls resting against opposite upright sides of the space to be filled and having a maximum permitted width B, in which, when an object is placed in an intermediate wall, allowance is made for the contour of the two adjacent walls by calculating said contour in the direction from which the objects are placed and then always retaining a width, once calculated, of an adjacent wall during the calculation as the calculated contour until a greater width is found and in which use is made of nested lists with intervals representing dimensions within the space.

FIG. 4

The invention relates to a method of filling a space having essentially the shape of a rectangular parallelepiped with objects having essentially the shape of a rectangular parallelepiped.

The placing of objects in a space, such as the placing of parcels in, for example, a container used by the postal services or on a pallet, and the placing of containers having different dimensions in a hold of, for example, a ship, has until now been done essentially manually, an operator attempting to achieve an optimum packing density on the basis of his experience. It will be clear that it is desirable to automate the said packing at least partially, particularly if this were to be accompanied by an increase in the packing density, that is to say a more optimum use of the available space. A problem in this connection is that the calculation of the free space still available in a space partially filled with objects is very complicated, particularly if the objects already placed have different dimensions. In addition, the calculations have always to be carried out again after placing a new object.

In the paper entitled "A computer-based heuristic for packing pooled shipment containers" by H. Gehring et al. in the European Journal of Operational Research 44(1990), pages 277-288, the abovementioned problem is also described and an initial starting point is provided for finding a solution to it by heuristic means. For this purpose, it is assumed as a starting point that all the objects to be packed are rectangular boxes whose dimensions are known, that the boxes can be placed in any position whatsoever of the six possible positions and that every box can be placed near every other box and also on top of every other box and in any place whatsoever in the container. The dimensions of all the boxes to be placed are stored in a memory and the object of the paper is to provide the carrier with a list specifying the position of every box in the container so that the carrier is able to pack on the basis of said list and no longer needs to arrive at an optimum packing density on the basis of his experience. According to said paper, the boxes are packed in layers, starting with a layer or wall against the rear wall of the container and then proceeding forward layer-by-layer. The paper recognises that it is a problem in terms of computation time to obtain an up-to-date representation of the remaining free space whenever a box has been placed.

The object of the invention is to simplify this problem to such an extent that it is possible to calculate the free space in a space having essentially the shape of a rectangular parallelepiped partially filled with objects having essentially the shape of a parallelepiped with an acceptable computation time, the calculation of the free space which results whenever a new object has been placed being relatively simple. At the same time, the object of the invention is also to make the known method suitable for complete automation as a result of the fact that a predetermined number of parcels is present in a physical buffer space, the dimensions of said parcels also being stored in a memory. From this stock, a parcel to be placed is always selected in accordance with the rules to be described below and said parcel can then be placed in the container immediately by, for example, a robot, after which a new parcel taken from the bulk stock of parcels to be transported is added to the buffer stock, the dimensions of said parcel then also being stored in the memory.

For this purpose, the invention provides a method of the abovementioned type in which the dimensions of a predetermined number of objects are stored in a memory, in which the objects are placed step-by-step in the form of at least two walls, the respective outsides of the innermost and the outermost wall resting against opposite upright sides of the space to be filled and having a maximum permitted width B, in which, when an object is being placed in an outer wall, objects having a width w, with $q.B \leq w \leq B$ and $0 < q < 1$ a predetermined factor, are stacked step-by-step, in which, when an object is placed in an intermediately situated wall, allowance is made for the contour of the two adjacent walls by calculating said contour in the direction from which the objects are placed and then always retaining a width, once calculated, of an adjacent wall during the calculation as the calculated contour until a greater width is found.

The invention will be explained below on the basis of an exemplary embodiment by reference to the drawing, in which:

Figure 1 shows a plan view of a container to be filled;
Figure 2 shows a side view of a stacked side wall along the line II-II in Figure 1;
Figure 3 shows a side view of an intermediate wall along the line III-III in Figure 2;
Figure 4 shows a rear view of two stacked walls;
Figure 5 shows an explanation of the minimum-step concept;
Figures 6 A-C show an explanation of the formulation of an interval list for a side wall;
Figures 7 A-D show an explanation of the formulation of an interval list for an intermediate wall;
Figure 8 shows a flow chart for the placing of a parcel in a side wall;
Figure 9 shows a flow chart for the placing of a parcel in an intermediate wall, and
Figure 10 shows a flow chart for the adjustment of the interval list used in Figure 8.

For the sake of clarity, an exemplary embodiment will be described in which only three walls are stacked, namely two side walls against the sides of a container and an intermediate wall. The principle according to the invention is, however, also applicable in the case of a plurality of intermediate walls and in the case of only two outside walls. Moreover, although the placing of parcels in a container is always discussed below, but the procedures can be applied with the same effect in filling a pallet with parcels.

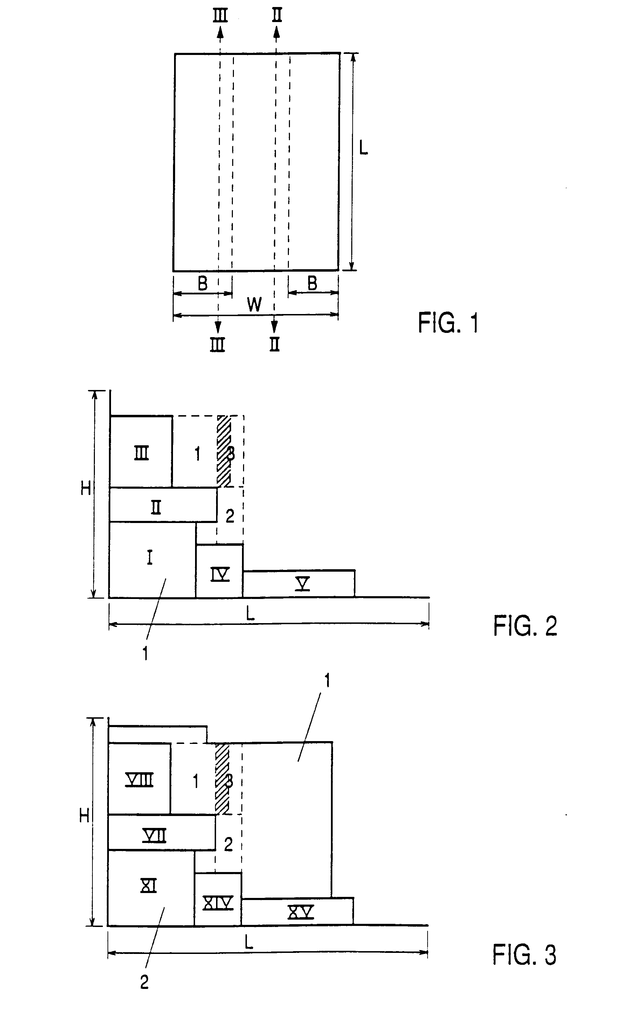

Figure 1 shows a plan view of a container 1 having a length L, a width W and a height H not shown in the figure. In the example, the container is filled from above. Hereinafter the dimensions of parcels to be placed in the container 1 will be specified by l, w and h for the length, width and height, respectively.

Figure 2 shows a cross section along the line II-II in Figure 1 of a possible situation which may arise during the packing of the container 1. In the placing seen in Figure 2, a placing starting in the bottom left-hand corner of the container has been assumed. Figure 2 shows the situation in which five parcels I - V have been placed. In placing parcels in an outside wall, the following rules are followed:

- A parcel for an outside wall has a width w meeting the requirement: $qB \leq w \leq B$, with B a predetermined maximum width for a side wall and q a predetermined factor, for example q = 0.6. The value of B can be different for the two side walls. This procedure prevents too narrow parcels being placed, which would adversely affect the stability of the wall.
- In placing a parcel, it must not project above the parcels already placed in the wall in order that a sloping staircase configuration is obtained and continues to be maintained.
- In the staircase configuration, 1) an attempt is first made to place a parcel, to be placed subsequently, on the highest (rearmost) step of the staircase and if this is not possible, 2) an assessment is made of whether a parcel can be placed on the next lower step. If 1) and 2) are found to be impossible, an assessment is made of whether a parcel can be placed on the highest step with an overhang of, for example, 30%. The possibilities 1, 2 and 3 are indicated diagrammatically in Figure 2. If none of the three possibilities leads to a result, the construction of the wall concerned is halted. It would of course be possible to try out still other criteria for placing a parcel, but this requires a disproportionately large amount of additional computation time, which is in conflict with the object of the invention.

In the above manner, the outermost walls are generally built up more or less simultaneously by alternately placing a parcel in the left-hand and in the right-hand wall. Of course, the success in building up walls which are as complete as possible is dependent on the number of parcels whose dimensions are stored in a memory. Generally, the storage of the dimensions of 30 parcels to be placed is found to lead to acceptable results. However, the distribution in terms of dimensions within a group of parcels to be placed is also of great importance. In the case of parcels with mutually differing dimensions, it is generally true that the greater the variation in dimensions is, the better the packing density ultimately achievable.

In packing an intermediate wall, in the present example, a single wall between two outside walls, allowance is also made for the width w of the parcels and for the contour of the adjacent walls in attempting to fill the free space remaining between the two outside walls in an optimum manner, which is not only beneficial for the packing density, but also for the stability of the packing.

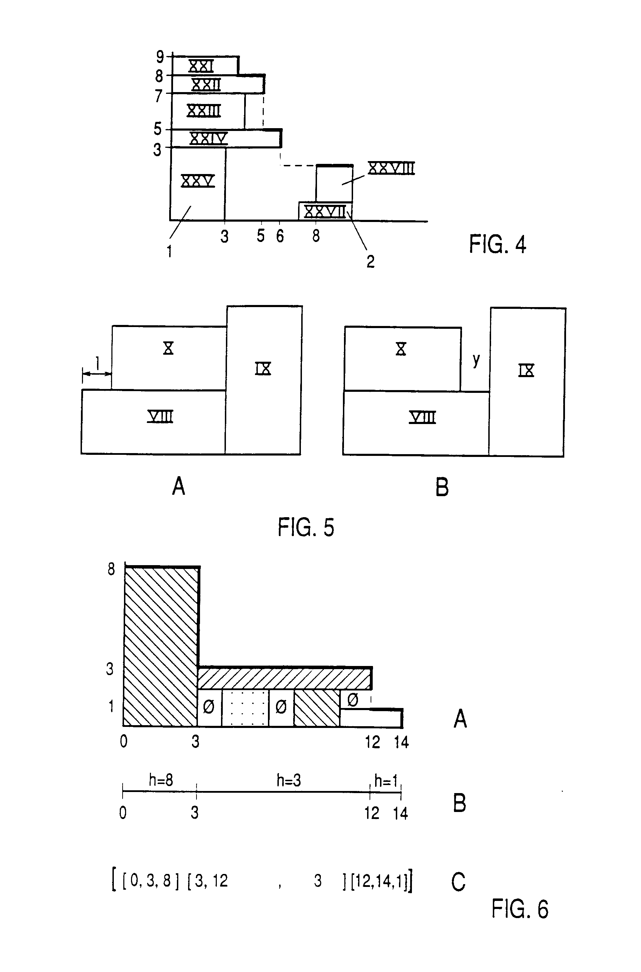

The building-up of an intermediate wall is explained on the basis of Figures 3 and 4. For the sake of simplicity, a single side wall 1 and an intermediate wall 2 have been assumed in these figures because the same applies mutatis mutandis to the other side wall as to side wall 1.

In building up an intermediate wall, the following rules apply:

- no parcel may be placed in an intermediate wall in such a way that it projects above the highest level of the adjacent walls. If this criterion did not apply, a parcel in the intermediate wall projecting over the boundaries of the side walls would be capable of seriously impeding further stacking of the side walls.
- During placing, the contour of the adjacent walls, as viewed in the width direction, is taken into consideration.

In other respects, an intermediate wall is also stacked step-by-step, preferably simultaneously with the outside walls, the abovementioned three possibilities for the placing of a parcel again being assessed consecutively before it is placed.

Figure 4 shows a possible side view of a stacked side wall, in which connection it is pointed out that this relates to a different stacking to that shown in Figure 2. Because the parcels are placed in the container from above, so-called top loading, a parcel can only be placed at a particular height in the intermediate wall if it is able to pass, in terms of its width, all the parcels situated higher up in the side walls. In Figure 4, this is determined for side wall 1 by the width of parcel XXIV when placing a parcel on the bottom of the container in the central wall 2. To pack the container from the front instead of from above, a corresponding contour has to be determined, but in this case seen in the longitudinal direction of the container. In Figure 4, the contour referred to is indicated by a thick line for the case where a parcel is being placed in the intermediate wall on an underlying, already placed parcel XXVIII.

To illustrate the results obtained by the invention, Tables I and II below give the packing densities which were obtained for different values of the width B of a side wall (Table I) and for varying numbers of parcels whose dimensions are stored in a memory. The values for Tables I and II were obtained for a container having dimensions of L x W x H = 60 x 80 x 140 cm and with the same set of parcels in all cases, the two largest parcels in said set having the dimensions 30 x 31 x 40 cm and 11 x 52 x 70 cm, respectively, the smallest having the dimensions 5 x 10 x 13 cm and the remainder having intermediately situated values. The packing density was defined as: {total volume of the placed parcels/total volume of the container} x 100%. For the sake of simplicity only two walls, a side wall and an intermediate wall, have been assumed in formulating the tables.

## TABLE I

| Wall width B (cm) | % | | % | Wall width B (cm) |
|---|---|---|---|---|
| | | 62 | | 45 |
| | | 62 | | 44 |
| 16 | 31 | 71 | | 43 |
| 17 | 27 | 71 | | 42 |
| 18 | 31 | 58 | | 41 |
| 19 | 52 | 70 | | 40 |
| 20 | 48 | 72 | | 39 |
| 21 | 65 | 74 | | 38 |
| 22 | 45 | 74 | | 37 |
| 23 | 50 | 74 | | 36 |
| 24 | 71 | 66 | | 35 |
| 25 | 52 | 61 | | 34 |
| 26 | 63 | 58 | | 33 |
| 27 | 71 | 28 | | 32 |
| 28 | 38 | 65 | | 31 |
| 29 | 59 | 61 | | 30 |

Average 64

## TABLE II

| Buffer size | 20 | 30 | 40 |
|---|---|---|---|
| Wall width B (cm) | % | % | % |
| 30 | 07 | 61 | 70 |
| 31 | 55 | 65 | 73 |
| 32 | 23 | 28 | 46 |
| 33 | 47 | 58 | 57 |
| 34 | 60 | 61 | 61 |
| 35 | 47 | 66 | 69 |
| 36 | 65 | 74 | 69 |
| 37 | 65 | 74 | 72 |
| 38 | 64 | 74 | 68 |
| 39 | 64 | 72 | 60 |
| 40 | 56 | 70 | 63 |
| 41 | 52 | 58 | 74 |
| 42 | 39 | 71 | 67 |
| 43 | 39 | 71 | 70 |
| 44 | 49 | 62 | 71 |
| 45 | 73 | 62 | 70 |
| Average per column | 54 | 64 | 66 |

For further clarification it is pointed out that, in the case of the set of parcels described above and of a container having the dimensions described above, a packing density of 73% corresponds to 60 placed

4

parcels.

From Table I it is evident that a greater value of B, for example B > 30 cm, generally leads to a greater packing density, which is explained by the fact that, for a greater value of B, the choice of available parcels is greater. For an excessively high value of B, however, the packing density decreases again because the possibilities for stacking the intermediate wall then decrease.

From Table II it is evident that, as must be expected, the size of the buffer memory has a large effect and a larger buffer memory results in a greater packing density. A balance has therefore to be struck between, on the one hand, the cost of a large buffer memory and, on the other hand, the importance of as high a packing density as possible. As is evident from the table, a buffer stock of 30 parcels is a reasonable compromise, with no excessively large sudden changes occurring in the different packing densities for different wall widths.

In stacking the walls, small shallow steps in the staircase viewed in the longitudinal direction of the wall can have adverse consequences because such a small step may preclude the above stacking possibilities referred to above as 1 and 3, with the result that only possibility 2 is left as a real possibility, which reduces, of course, the chance that a suitable parcel is found. According to a further embodiment of the invention, therefore, the "minimum-step" concept is introduced. The minimum-step value is at most equal to the minimum dimension of each of the parcels to be placed. If the length of a step after a parcel has been placed in the wall is less than the minimum step, said parcel is pushed to the end of the step, thereby preventing an excessively short step. This is shown diagrammatically in Figure 5 for a parcel X which is being placed on a step formed by the parcels VIII and IX; an excessively short step having a length l is present in Figure 5A, but this has been eliminated in Figure 5B. The fact that the minimum step is smaller than the smallest parcel dimension prevents a parcel dropping into the gap denoted by y in Figure 5B during further stacking. For the subsequent calculations, the gap formed is ignored and the course of action is as if the step with the parcel X thereon is a completely continuous step.

Table III shows the packing densities obtained for various minimum-step values, in cm, for various wall widths (B). The values were obtained with the same set of parcels in all cases, but in set a, b and c, respectively, the parcels were always presented in a different sequence. It can generally be stated that the introduction of a minimum-step value increases the packing density.

### TABLE III

| Set | a | a | b | b | c | |
|---|---|---|---|---|---|---|
| Buffer size | 30 | 30 | 30 | 30 | 30 | |
| Minimum step | 0 | 3 | 3 | 4 | 3 | |
| Wall width B (cm) | % | % | % | % | % | Row average |
| 30 | 44 | 55 | 59 | 61 | 50 | 56 |
| 31 | 60 | 64 | 65 | 65 | 42 | 62 |
| 32 | 53 | 28 | 28 | 28 | 35 | 36 |
| 33 | 52 | 55 | 46 | 58 | 45 | 52 |
| 34 | 38 | 59 | 42 | 61 | 50 | 52 |
| 35 | 56 | 70 | 65 | 66 | 53 | 62 |
| 36 | 53 | 74 | 72 | 74 | 51 | 66 |
| 37 | 38 | 56 | 70 | 74 | 51 | 60 |
| 38 | 44 | 56 | 73 | 74 | 58 | 62 |
| 39 | 54 | 59 | 68 | 72 | 66 | 64 |
| 40 | 38 | 69 | 62 | 70 | 72 | 62 |
| 41 | 39 | 14 | 63 | 58 | 59 | 51 |
| 42 | 24 | 16 | 70 | 71 | 38 | 48 |
| 43 | 64 | 24 | 70 | 71 | 38 | 56 |
| 44 | 64 | 63 | 56 | 62 | 50 | 61 |
| 45 | 53 | 73 | 56 | 62 | 69 | 64 |
| Column average | 48 | 51 | 60 | 64 | 51 | 55 |

In the method according to the invention, use is made of nested lists with intervals in determining the remaining free space.

Figure 6A shows a side view of a simple single wall stack having a contour which is indicated by a thick line and indicates the steps for the possible placing of subsequent parcels. The dimensions which are important for producing the interval list are indicated for the wall. The regions indicated by $\phi$ in the figure are empty spaces which are ignored as a consequence of using a minimum-step value. Figure 6B shows the intervals with the associated heights and Figure 6C the interval list. As is evident from the figure, for a side wall in which the width does not play a part, a nested interval list is obtained by consecutively giving in groups a length span of the contour, followed by the height of the contour over said span. The interval is designated by means of the starting point, finishing point and height parameters of the interval, indicated between "[" and "]". The parameter height has been omitted as it is not relevant.

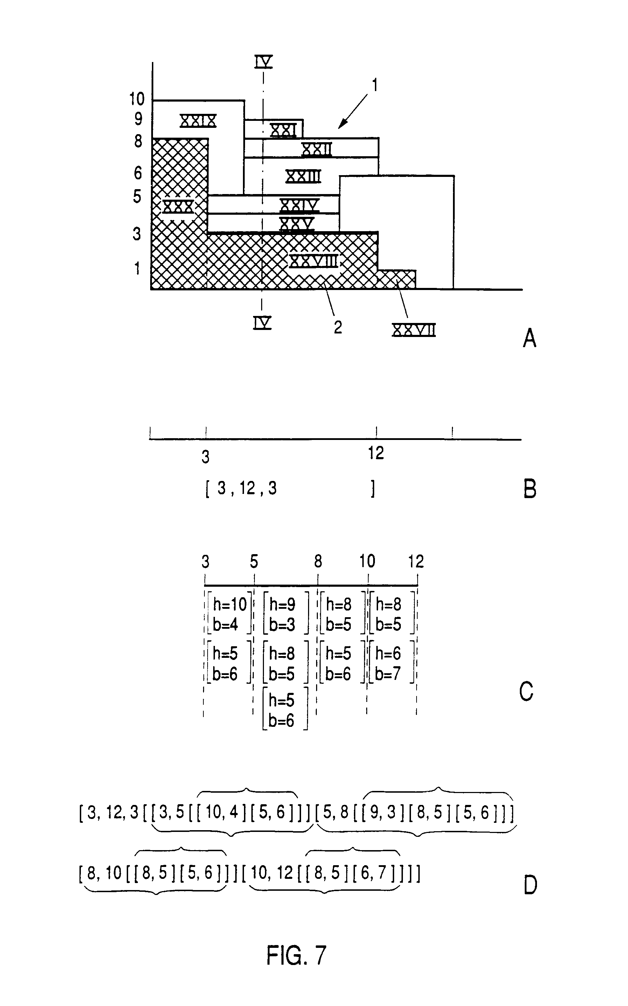

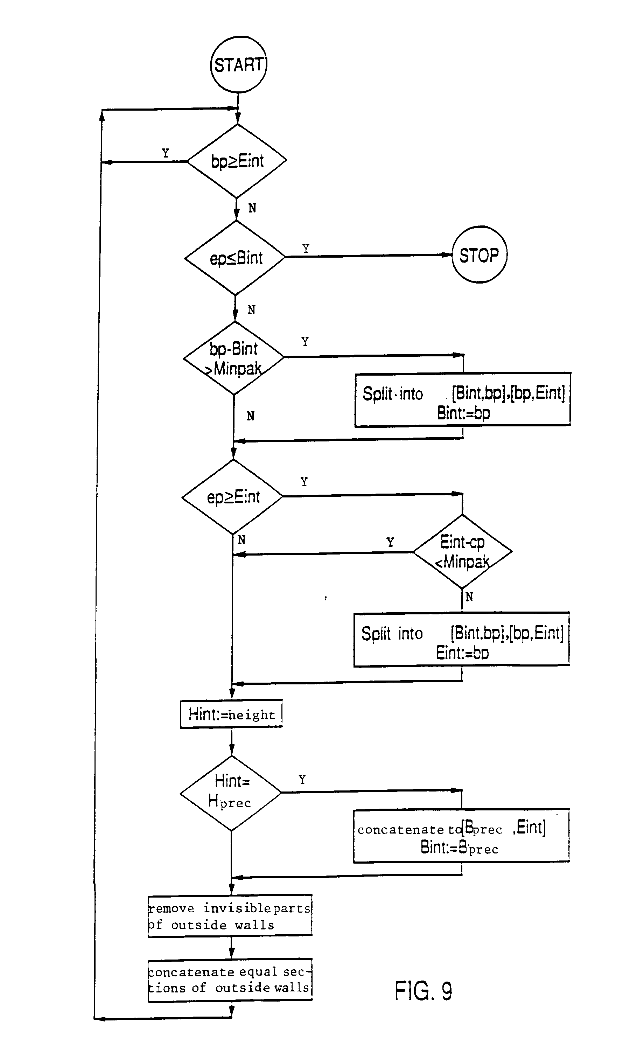

Figure 7 shows the way in which the interval lists can be obtained for an intermediate wall. Figure 4 already discussed above is a section along the line IV-IV in Figure 7A. Figure 7 also shows two parcels XXIX and XXX which are not visible in Figure 4 and of which the first mentioned has a width of w = 4. Figure 7B shows the interval and the interval list for the contour in Figure 7A if only the length and the height of the interval are taken into consideration in the same way as in Figure 6. Figure 7C shows the way in which the width contour shown in Figure 4 is also reproduced in intervals. In this figure, four subintervals of the interval 3-12 are indicated, these being necessary to take the various widths of wall 1 into consideration. The height at which the width of the wall 1 undergoes a change is indicated for every subinterval, only those heights being indicated at which the width of the wall increases on going from top to bottom along wall 1. This takes into consideration the principle described above, in accordance with which only the greatest width of the contour of wall 1 is of importance in order to be able to determine which parcel can be placed in the intermediate wall by means of top loading. Finally, Figure 7D shows the interval list which is obtained with the aid of Figures 7B and C and with which the intervals can be recalculated after placing a new parcel in the intermediate wall. The various subintervals are indicated in Figure 7D with "{" signs.

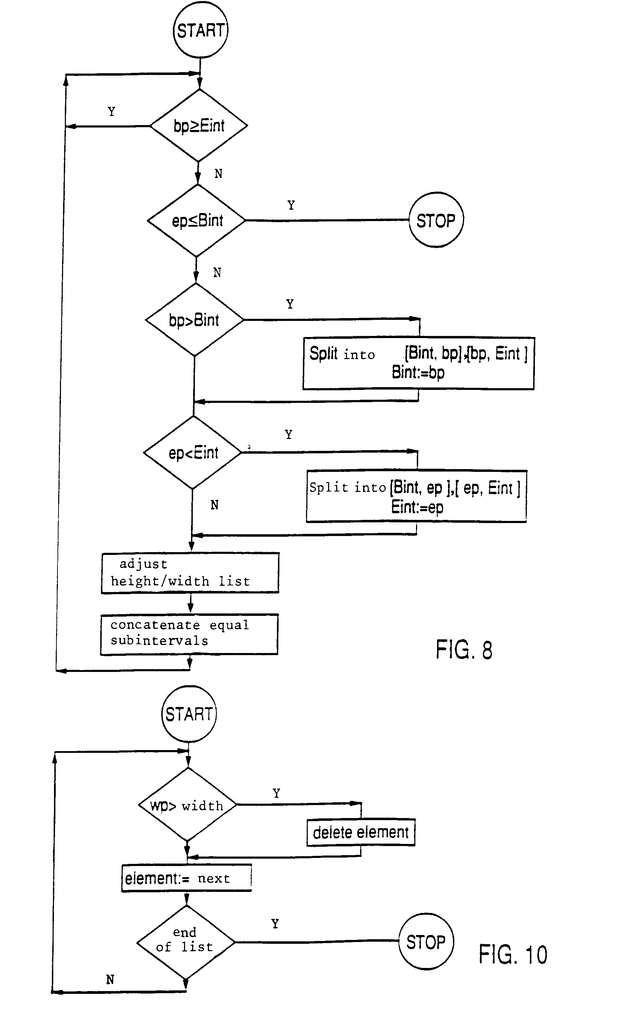

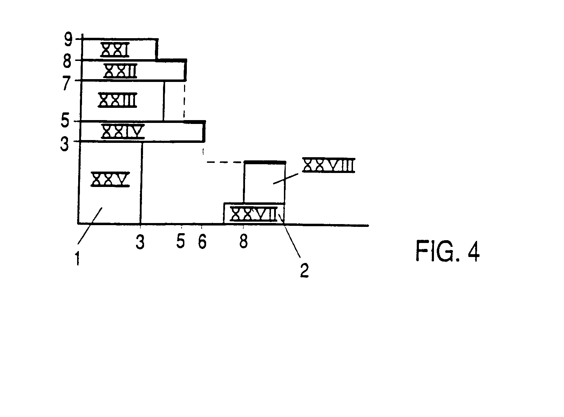

Figures 8 and 9 show three flow charts which indicate the method of determining if a parcel can be placed in a side wall or a centre wall, respectively, in accordance with the procedures given above, while Figure 10 shows the steps in the flow chart shown in Figure 9 in accordance with which the height/width list can be adjusted after placing a parcel.

The following abbreviations have been used in the flow charts:

$B_{int}$ = starting point of interval;
$E_{int}$ = finishing point of interval;
$H_{int}$ = height of interval;
$B_{prec}$ = starting point of preceding interval;
$H_{prec}$ = height of preceding interval;
$b_p$ = starting point of parcel;
$e_p$ = finishing point of parcel;
$h_p$ = height of parcel;
$w_p$ = width point of parcel;
Minpak = minimum-step value.

Furthermore, in all three flow charts, a calculation from left to right looking into the container as shown, for example, in Figures 6 and 7A is assumed, and the starting point is always at the front of the list of intervals. In Figure 10, an "element" is determined by [height, width].

The 'Split into' procedures of the Figures 8 and 9 means:
if a starting point ($b_p$) or a finishing point ($e_p$) of a parcel lies within an interval [$B_{int}$, $E_{int}$], then split into two separate intervals as indicated.

The 'concatenate to' procedure of Figure 9 means: add adjacent intervals with equal height ($H_{int} = H_{prec}$) to one interval as indicated.

The 'adjust height/width list' and 'concatenate equal subintervals' procedures of Figure 8, and the procedures 'remove invisible parts of outside walls' and 'concatenate equal sections of outside walls' procedures of Figure 9 determine the contours according to Figure 4 and its corresponding description.

## Claims

1. Method of filling a space having essentially the shape of a rectangular parallelepiped with objects having essentially the shape of a rectangular parallelepiped, characterised in that the dimensions of a predetermined number of objects are stored in a memory, in that the objects are placed step-by-step in the form of at least two walls, the respective outsides of the outermost walls resting against opposite upright sides of the space to be filled and having a maximum permitted width B, in that, when an object is being placed in an outer wall, objects having a width w, with $q.B \leq w \leq B$ and $0 < q < 1$ a predetermined factor, are stacked step-by-step, in that, when an object is placed in an intermediately situated wall, allowance is made for the contour of the two adjacent walls by calculating said contour in the direction from which the objects are placed and then always retaining a width, once calculated, of an adjacent wall during the calculation as the calculated contour until a greater width is found.

2. Method according to Claim 1, characterised in that, for the calculations, use is made of nested lists with intervals representing dimensions within the space.

3. Method according to Claim 1 or 2, characterised in that, during the placing of an object on a step formed in a wall by preceding step-by-step stacking, whether the object projects above the objects already placed in said wall after it has been placed is calculated, and if it is the object is not placed.

4. Method according to at least one of the preceding claims, characterised in that, during the placing of an object on a step in an intermediate wall, whether the object projects above the objects already placed in the adjacent walls after it has been placed is calculated, and if it is the object is not placed.

5. Method according to at least one of the preceding claims, characterised in that, during the placing of an object on a step, whether the object to be placed can be placed on the step concerned is first calculated and if this is not possible, whether the object can be placed on the next lower step is calculated, and if this is also found to be impossible, whether the object can be placed on the step first mentioned with an overhang having a predetermined percentage is calculated.

6. Method according to at least one of the preceding claims, characterised in that, if a step is left which has a length smaller than a predetermined value on placing an object on a step, the object is placed in such a manner that the side of the object which is situated at the front of the step is in line with the front edge of the step on which the object is placed.

7. Method according to Claim 6, characterised in that the predetermined value is at most equal to the smallest dimension of all the objects to be placed.

FIG. 1

FIG. 2

FIG. 3

FIG. 4

A          B

FIG. 5

A

B

$\big[\,[0, 3, 8]\,[3, 12 \qquad , \qquad 3 \quad ][12,14,1]\big]$          C

FIG. 6

**A**

10
9
8
6
5
3
1

IV

1

ⅩⅩⅨ ⅩⅩⅠ ⅩⅩⅡ ⅩⅩⅢ ⅩⅩⅣ ⅩⅩⅤ ⅩⅩⅧ ⅩⅩⅦ

IV

2

**B**

3          12

[ 3 , 12 , 3          ]

**C**

3        5        8        10        12

| h=10 | h=9 | h=8 | h=8 |
| b=4  | b=3 | b=5 | b=5 |

| h=5 | h=8 | h=5 | h=6 |
| b=6 | b=5 | b=6 | b=7 |

| h=5 |
| b=6 |

**D**

[ 3, 12, 3 [ [ 3, 5 [ [ 10, 4 ] [ 5, 6 ] ] ] [ 5, 8 [ [ 9, 3 ] [ 8, 5 ] [ 5, 6 ] ] ]

[ 8, 10 [ [ 8, 5 ] [ 5, 6 ] ] ] [ 10, 12 [ [ 8, 5 ] [ 6, 7 ] ] ] ]

FIG. 7

FIG. 9

START

```
bp≥Eint  --Y-->
   |N
ep≤Bint  --Y--> STOP
   |N
bp>Bint  --Y--> Split into [Bint, bp],[bp, Eint ]
   |            Bint:=bp
   |
ep<Eint  --Y--> Split into [Bint, ep ],[ ep, Eint ]
   |N           Eint:=ep
   |
adjust
height/width list
   |
concatenate equal
subintervals
```

FIG. 8

START

```
wp> width  --Y--> delete element
   |
element:= next
   |
end
of list  --Y--> STOP
   |N
```

FIG. 10

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A,D | EUROPEAN JOURNAL OF OPERATIONAL RESEARCH vol. 44, 1990, NL pages 277 - 288 H. GEHRING ET. AL. 'A computer-based heuristic for packing pooled shipment containers' * the whole document * | 1 | G06F15/24 B65G61/00 |
| A | EP-A-0 389 985 (R.J. REYNOLDS TOBACCO COMPANY) * column 2, line 1 - column 3, line 13 * | 1 | |
| A | FORDERN UND HEBEN. vol. 40, no. 10, October 1990, MAINZ DE pages 726 - 727 G. JORDAN 'Chaotisch und automatisch palettieren' * the whole document * | 1 | |
| A | US-A-4 692 876 (TENMA ET. AL.) * column 3, line 9 - column 4, line 14 * * column 7, line 22 - line 34 * | 1 | TECHNICAL FIELDS SEARCHED (Int. Cl.5 ) |
| A | US-A-4 641 271 (KONISHI ET. AL.) * column 2, line 21 - line 46 * | 1 | G06F B65G |

-----

The present search report has been drawn up for all claims

| Place of search | Date of completion of the search | Examiner |
|---|---|---|
| THE HAGUE | 23 OCTOBER 1992 | BURÖ S.P. |